# EUROPEAN PATENT APPLICATION

(11) **EP 4 318 945 A1**
(43) Date of publication of application: **07.02.2024**
(21) Application number: 22919886.6
(22) Date of filing: 21.10.2022
(51) Int. Cl.: H03H 9/17, H03H 3/02

(54) **BAW FILTER STRUCTURE AND PREPARATION METHOD**

(30) Priority: 14.01.2022 CN 202210044126
(71) Applicant: Fujian Sunwise Semiconductor Technology Co., Ltd., Longyan, Fujian 364000 (CN)
(72) Inventor: WANG, Mengyuan, Longyan, Fujian 364000 (CN)
(74) Representative: Sun, Yiming
(86) International application number: PCT/CN2022/126825
(87) International publication number: WO 2023/134252

(57) **Abstract**

The present disclosure provides a bulk acoustic wave (BAW) filter structure and a preparation method thereof, and relates to a radio frequency (RF) filtering technology. The following solution is proposed in consideration of unachievable industrial production due to a stress problem in the prior art: piezoelectric film elements independent of each other are formed on a surface of an epitaxial substrate to form a transfer structure; resonant regions are defined on a supporting substrate and covered with bonding units to obtain a bonding structure; upper and lower surfaces of the transfer structure are reversed, and bottom electrode units are bonded to the resonant regions correspondingly one to one to obtain a BAW structure; and the epitaxial substrate is removed, and top electrode units are formed on surfaces of the piezoelectric film elements that are in contact with the epitaxial substrate previously. With the advantages of a simple structure, a simple process, high isolation and a minimal stress problem, the BAW filter structure of the present disclosure can achieve batch production with low cost, high efficiency and high yield, and is suitable for industrial production, especially applicable to industrial fabrication of a monocrystalline film device.

## Description

### TECHNICAL FIELD

The present disclosure relates to a radio frequency (RF) filtering technology, and in particular, to a bulk acoustic wave (BAW) filter structure and a preparation method thereof.

### BACKGROUND

An RF filter is one of the important devices in the field of wireless communication. With the arrival of the era of big data and Internet of Things, a filter assembled into an RF front-end is bound to be developed toward high frequency, low loss, miniaturization, integration, and the like. A BAW filter based on a piezoelectric material is a preferred RF filter that can achieve a technical indicator of a center frequency of several Ghz by cascading a plurality of BAW resonators according to a certain topology. Compared with a traditional ceramic filter and a surface acoustic wave filter also based on a piezoelectric material, the BAW filter has an incomparable size advantage as well as advantages such as a high operating frequency band and a high power capacity.

The basic structure of a BAW resonator is a sandwich composite film structure composed of a bottom electrode, a piezoelectric film, and a top electrode, and the BAW resonator operates based on the following principle: a bulk acoustic wave propagating longitudinally is excited by the piezoelectric film under the action of an alternating current electric field, and the bulk acoustic wave is reflected by upper and lower interfaces of a composite film and thus confined within the composite film to oscillate back and forth to form a standing wave, thereby realizing resonance. Usually, a cavity or a Bragg reflection layer for reflecting the acoustic wave is formed below the bottom electrode of the BAW resonator, and such two structures are a film bulk acoustic resonator (FBAR) and a solidly mounted resonator (SMR), respectively.

In a traditional process, a common method for forming an FBAR cavity includes firstly etching a pit in a substrate, filling the pit with a material prone to wet or dry chemical corrosion as a sacrificial layer, then performing surface polishing by chemical mechanical polishing, followed by depositing a bottom electrode, a piezoelectric film, and a top electrode in sequence to obtain a composite film structure composed of them, and finally etching the composite film to form a release window to corrode the sacrificial layer to form a cavity. The article "research on preparation techniques of low-stress scandium-doped aluminum nitride films, RESEARCH & PROGRESS OF SOLID STATE ELECTRONICS, Vol. 41, No. 4, August 2010" describes a serious problem of film breakage or shedding due to film stress in preparing an FBAR device, leading to a failure of the device. Compared with a polycrystalline piezoelectric material, a monocrystalline piezoelectric material is beneficial to obtaining a higher electromechanical coupling coefficient and reducing acoustic wave propagation loss and has attracted increasing attention in the industry. However, the stress problem of a monocrystalline piezoelectric film is especially prominent, and therefore, the problem of device breakage caused by stress is most important in an FBAR device with a monocrystalline piezoelectric film.

Chinese patent documents No. 201611135804.8 and No. 201610028453.4 describe technical solutions of an FBAR and an SMR by using methods of transferring a monocrystalline or polycrystalline piezoelectric material through substrate lift-off, respectively. However, these methods, in which entire wafer bonding and substrate lift-off are carried out for piezoelectric films, have the following disadvantages: (1) a mismatch between coefficients of thermal expansion of a piezoelectric film and a substrate is one of major causes of film stress, and a deformation quantity is decided by a formula ΔL=α·ΔT·L, where α represents a coefficient of thermal expansion, ΔT represents a temperature variation, and L represents a length. It can be seen that the warping degree and stress of the film are directly proportional to the size thereof. The warping degree and stress of the piezoelectric film subjected to entire wafer bonding are both relatively large, which may easily cause collapse and breakage of a resonant structure during substrate lift-off and subsequent device fabrication, leading to a high device failure rate. (2) Entire wafer bonding requires high surface evenness of a supporting substrate, and therefore, chemical mechanical polishing has to be adopted, giving rise to problems of high process complexity and easy mechanical surface damage. (3) A filter constructed in a cascading manner usually requires the interconnection of the bottom and top electrodes of a plurality of BAW resonators, and if the entire wafer bonding method is adopted, interconnecting through holes needs to be formed by etching piezoelectric films. This process is difficult to implement and may easily cause collapse and breakage of the film.

It is not impossible to elaborately produce a chip by taking parameters such as stress, length, thickness, and temperature into overall consideration in a laboratory. However, a great problem may arise if the laboratory method is applied to industry. The above-mentioned methods cannot achieve rapid mass production and high yield required by industrialization.

### SUMMARY

An objective of the present disclosure is to provide a BAW filter structure and a preparation method thereof to solve the above-mentioned problems in the prior art.

A preparation method of a BAW filter structure described in the present disclosure includes:
a step of fabricating a transfer structure: forming two or more piezoelectric film elements independent of each other on a surface of an epitaxial substrate and forming bottom electrode units on the piezoelectric film elements correspondingly one to one to obtain the transfer structure;
a step of fabricating a bonding structure: defining two or more resonant regions independent of each other on a supporting substrate, covering the resonant regions with bonding units, respectively, and electrically interconnecting the bonding units as needed according to a patterning design to obtain the bonding structure, where a position of each resonant region is axisymmetric to a position of each piezoelectric film element; and
a step of transfer bonding: reversing upper and lower surfaces of the transfer structure and bonding the bottom electrode units to the resonant regions correspondingly one to one to obtain a BAW structure; removing the epitaxial substrate, and forming top electrode units on surfaces of the piezoelectric film elements that are in contact with the epitaxial substrate previously.

If the resonant region contains a sacrificial material, the sacrificial material may be removed after the removal of the epitaxial substrate.

The bonding unit may be made of a metal or an alloy material.

After the bonding units are electrically interconnected, an independently resonant first-order or multi-order topology may be formed for a BAW filter.

The resonant region may be provided with a sacrificial unit between the bonding unit and the supporting substrate, and the bonding unit may be provided with a release hole for exposing the sacrificial unit.

The sacrificial unit may be laid on the upper surface of the supporting substrate.

A cavity for accommodating the sacrificial unit is formed in the upper surface of the supporting substrate, and the bonding unit flatly covers the upper surface of the sacrificial unit.

The resonant region may be provided with a Bragg reflection unit between the bonding unit and the supporting substrate.

The piezoelectric film element may be made of a monocrystalline material or a polycrystalline material.

A BAW filter structure is obtained by using the preparation method.

A BAW filter structure and a preparation method thereof described in the present disclosure have the following advantages:
1. An existing technical route for an entire wafer transferred piezoelectric film is abandoned, and etching isolation is performed on the piezoelectric film before bonding such that stress thereof is released in advance and a warping degree of the film is reduced. Risks of collapse and damage of the piezoelectric film due to stress during subsequent processing such as substrate lift-off can be reduced, and the production yield may be significantly increased. Moreover, this method is especially suitable for solving the stress problem of a monocrystalline piezoelectric film.
2. The present solution adopts a manner that a bottom electrode unit in each unit structure is correspondingly bonded to a corresponding bonding unit instead of entire wafer bonding, which can be realized without requiring that a supporting substrate is absolutely flat as long as upper surfaces of bonding units are in a same plane. Therefore, it is unnecessary to perform chemical mechanical polishing on the supporting substrate. Thus, the problem of mechanical surface damage in a traditional method is avoided, and the process complexity is significantly reduced.
3. Isolation between BAW resonators is realized by etching a piezoelectric film in advance, and it is unnecessary to carry out an extra interconnecting through contact hole etching process for the piezoelectric film during subsequent cascading construction of a filter so that the process difficulty and cost can be significantly reduced.

Taking the above advantages into overall consideration, the BAW filter structure and the preparation method provided in the present disclosure can achieve low cost, high efficiency, and high yield in batch production because of a simple structure, a simple process, high isolation, and a minimal stress problem, and are suitable for use in industrial production, and especially applicable to industrial fabrication of a monocrystalline film device.

### BRIEF DESCRIPTION OF THE DRAWINGS

FIG. 1 is a flowchart 1 of Example 1 of a preparation method of a BAW filter structure according to the present disclosure;
FIG. 2 is a flowchart 2 of Example 1 of a preparation method of a BAW filter structure according to the present disclosure;
FIG. 3 is a flowchart 3 of Example 1 of a preparation method of a BAW filter structure according to the present disclosure;
FIG. 4 is a flowchart 4 of Example 1 of a preparation method of a BAW filter structure according to the present disclosure;
FIG. 5 is a flowchart 5 of Example 1 of a preparation method of a BAW filter structure according to the present disclosure;
FIG. 6 is a flowchart 6 of Example 1 of a preparation method of a BAW filter structure according to the present disclosure;
FIG. 7 is a flowchart 7 of Example 1 of a preparation method of a BAW filter structure according to the present disclosure;
FIG. 8 is a flowchart 8 of Example 1 of a preparation method of a BAW filter structure according to the present disclosure;
FIG. 9 is a flowchart 9 of Example 1 of a preparation method of a BAW filter structure according to the present disclosure;
FIG. 10 is a schematic diagram of a one-stage BAW filter structure according to the present disclosure;
FIG. 11 is an equivalent circuit diagram of a one-stage BAW filter structure according to the present disclosure;
FIG. 12 is a performance simulation diagram of a one-stage BAW filter structure according to the present disclosure;
FIG. 13 is a structural schematic diagram of a multi-stage BAW filter structure according to the present disclosure;
FIG. 14 is an equivalent circuit diagram of a multi-stage BAW filter structure according to the present disclosure;
FIG. 15 is a flowchart 1 of Example 2 of a preparation method of a BAW filter structure according to the present disclosure;
FIG. 16 is a flowchart 2 of Example 2 of a preparation method of a BAW filter structure according to the present disclosure;
FIG. 17 is a flowchart 3 of Example 2 of a preparation method of a BAW filter structure according to the present disclosure;
FIG. 18 is a flowchart 4 of Example 2 of a preparation method of a BAW filter structure according to the present disclosure;
FIG. 19 is a flowchart 5 of Example 2 of a preparation method of a BAW filter structure according to the present disclosure;
FIG. 20 is a flowchart 6 of Example 2 of a preparation method of a BAW filter structure according to the present disclosure;
FIG. 21 is a flowchart 1 of Example 3 of a preparation method of a BAW filter structure according to the present disclosure;
FIG. 22 is a flowchart 2 of Example 3 of a preparation method of a BAW filter structure according to the present disclosure;
FIG. 23 is a flowchart 3 of Example 3 of a preparation method of a BAW filter structure according to the present disclosure;
FIG. 24 is a flowchart 4 of Example 3 of a preparation method of a BAW filter structure according to the present disclosure; and
FIG. 25 is a flowchart 5 of Example 3 of a preparation method of a BAW filter structure according to the present disclosure;

### Reference numerals:

100-transfer structure: 110-epitaxial substrate, 120-piezoelectric film, 121-piezoelectric film unit, and 131-bottom electrode unit;
200-bonding structure: 210-supporting substrate, 221-sacrificial unit, 222-Bragg reflection unit, 231-bonding unit, and 232-release hole'
300-BAW structure; and
141-top electrode unit.

### DETAILED DESCRIPTION

A preparation method of a BAW filter structure described in the present disclosure may be used to manufacture an FBAR device or an SMR device. It is mainly intended to address a stress problem of a piezoelectric film to adapt to industrial large-scale production; meanwhile, at least beneficial effects of high isolation, simple process, and high yield are produced.

### Example 1

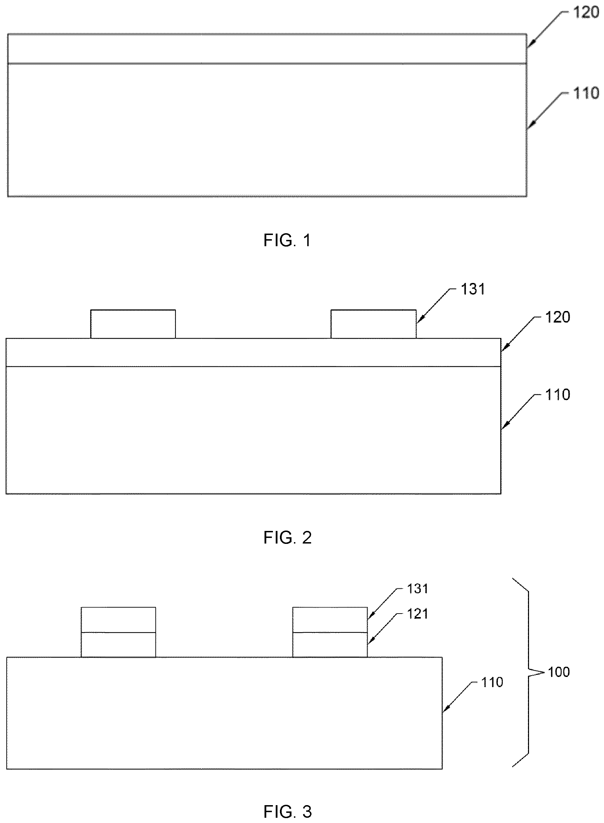

A piezoelectric film 120 having a certain thickness is deposited on an epitaxial substrate 110 by using an epitaxial growth process (e.g., metal-organic chemical vapor deposition (MOCVD), molecular beam epitaxy (MBE) or Pulsed Laser Deposition(PLD)), as shown in FIG. 1. The piezoelectric film 120 may be made of a monocrystalline material or a polycrystalline material. Compared with the polycrystalline material, the monocrystalline material has more superior electrical and acoustical properties. If the monocrystalline material is used, AlN, AlScN, ZnO, Ga₂O₃ or the like may be selected. A specific thickness of the piezoelectric film 120 may be selected according to a frequency band over which a made target device is applied.

A bottom electrode unit 131 is deposited on an upper surface of the piezoelectric film 120 and patterned according to a designed layout of a target device, as shown in FIG. 2.

The piezoelectric film 120 is etched until the epitaxial substrate 110 is exposed. The etched piezoelectric film 120 is split into two or more piezoelectric film elements 121 independent of each other, as shown in FIG. 3, and a transfer structure 100 is thus obtained for later use.

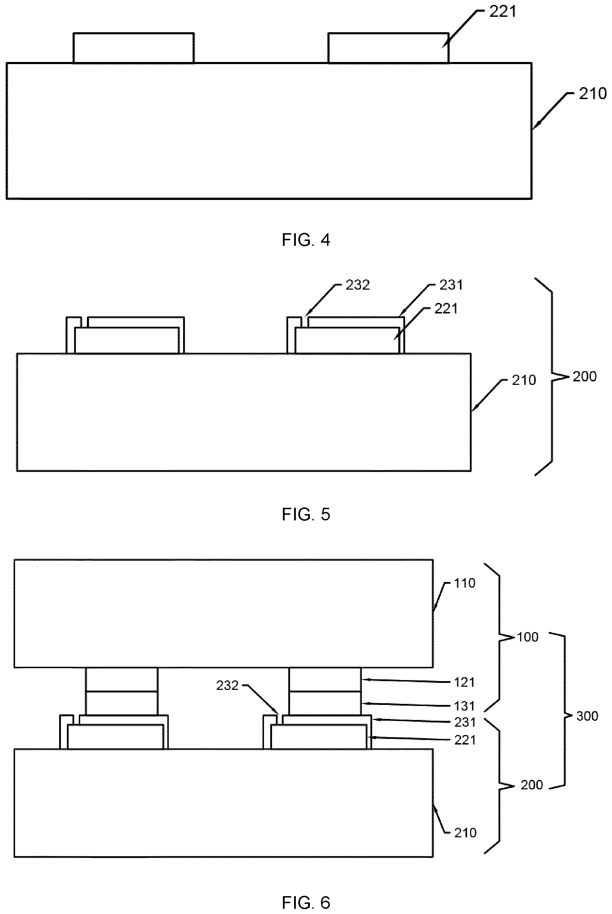

A supporting substrate 210 is provided additionally. A sacrificial material is deposited over the supporting substrate 210 and patterned according to the designed layout of the target device to obtain two or more sacrificial units 221 independent of each other, as shown in FIG. 4. To be correspondingly bonded to the preceding bottom electrode unit 131 subsequently, a position of each sacrificial unit 221 is axisymmetric to each piezoelectric film element 121. An axis of symmetry is taken as an axis of subsequent reversal of the transfer structure 100. The sacrificial units 221 are all located within a resonant region of the design layout.

A material (e.g., a metal or an alloy material) for bonding is deposited over the supporting substrate 210. The material for bonding at least overlays the sacrificial units 221 and is provided with release holes 232 for exposing the sacrificial units 221, as shown in FIG. 5, to obtain a bonding structure 200. The bonding unit 231 over each sacrificial unit 221 may be isolated or patterned according to the designed layout such that some specified bonding units 231 are electrically connected in a certain wire connection manner.

Upper and lower surfaces of the transfer structure 100 are reversed, and the bottom electrode units 131 are bonded to the bonding units 231 correspondingly one to one to obtain a BAW structure 300 as shown in FIG. 6. A bonding process may be fusion bonding, metal diffusion bonding, eutectic bonding, or the like. It only needs to be guaranteed that upper surfaces of the bonding unit are in the same plane before bonding. During bonding, the bottom electrode unit 131 is kept away from space over the release hole 232 so as not to block the release hole 232.

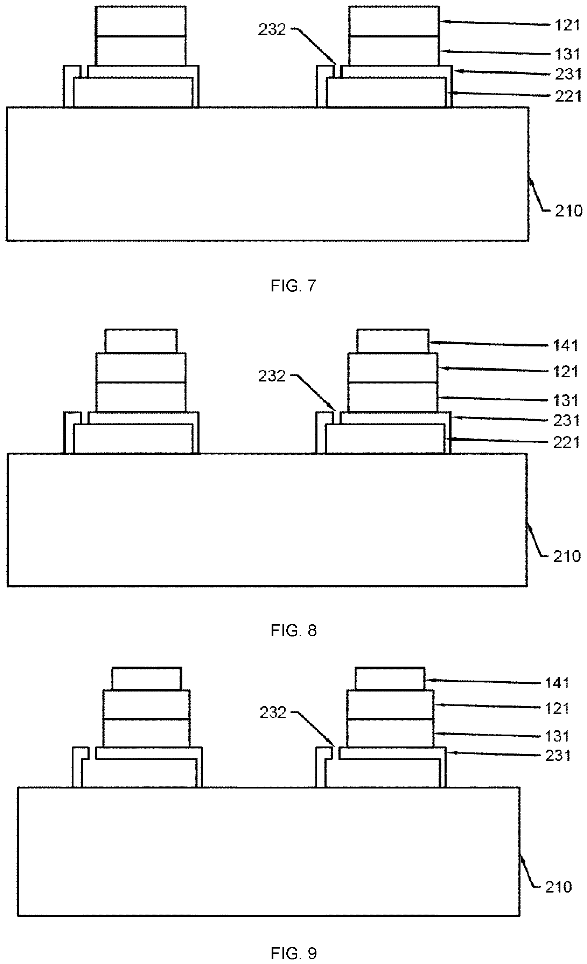

The epitaxial substrate 110 is removed by using a process such as mechanical thinning and dry or wet etching to expose surfaces of the piezoelectric film elements 121 that are in contact with the epitaxial substrate previously, as shown in FIG. 7.

Patterned top electrode units 141 are deposited on the exposed piezoelectric film elements 121 according to the designed layout to obtain a composite film structure of the top electrode units 141, the exposed piezoelectric film elements 121, and the bottom electrode units 131, as shown in FIG. 8.

The sacrificial units 221 are processed through the release holes 232 by solution corrosion or gas corrosion. The bonding units 231 below the composite film structure are enabled to have resonant cavities to obtain the target device. A BAW filter structure described in the present disclosure is also prepared by using the preparation method of this example, as shown in FIG. 9.

A target device in this example is an FBAR device.

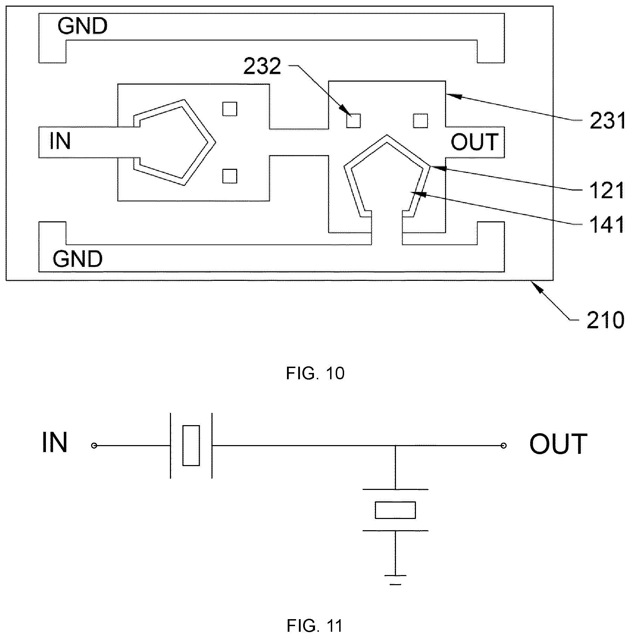

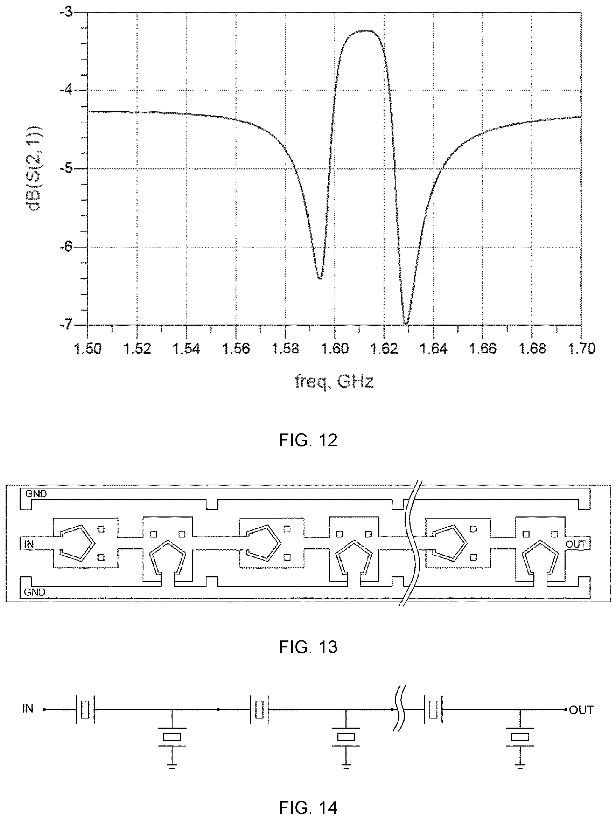

It needs to be additionally noted that the preparation method of the present disclosure can prepare a structure with two or more and hence inevitably a single one piezoelectric film element 121. However, the application scenario of a single one piezoelectric film element 121 is highly limited, which will not be described here. The specific number of the piezoelectric film elements 121 depends on the topology design requirement of the target device. When the number of the piezoelectric film elements 121 is two, the structure is the simplest one-stage topology, as shown in FIG. 10. An equivalent circuit of the one-stage topology is also as shown in FIG. 11, and the corresponding performance simulation thereof is as shown in FIG. 12. Real signal isolation can be achieved with two resonators. FIG. 12 indicates that the one-stage topology has a good filtering effect. A multi-stage topology made on the basis of the one-stage topology can inevitably achieve a good filtering function.

An expansion of the multi-stage topology is shown in FIG. 13, and an equivalent circuit thereof is shown in FIG. 14. Under the technical teaching of the present disclosure, a person skilled in the art can derive other topologies without creative efforts.

### Example 2

Compared with Example 1, a transfer structure 100 is prepared through a sample process in this example. A major difference from Example 1 is that the preparation process of a bonding structure 200 is different, resulting in a different structure of a target device.

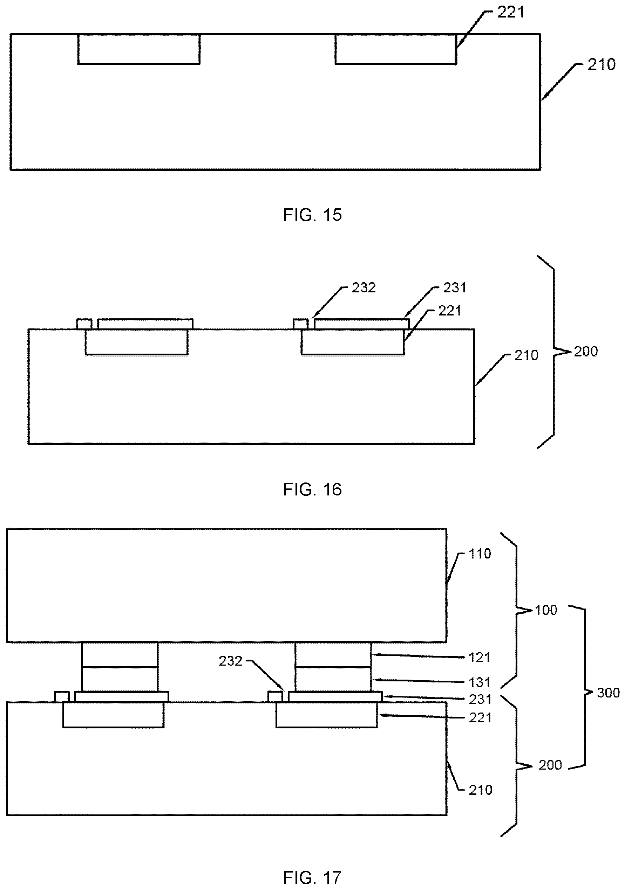

When the bonding structure 200 is prepared, a cavity extending downwards is formed in the upper surface of a supporting substrate 210 by using a publicly known process and flatly filled with a sacrificial material to form a sacrificial unit 221 as shown in FIG. 15.

The sacrificial unit 221 is flatly covered with a bonding unit 231 with a release hole 232 for post-processing to obtain the bonding structure 200 as shown in FIG. 16.

The transfer structure 100 is reversed and bonded to the bonding structure 200 to obtain a BAW structure 300 as shown in FIG. 17.

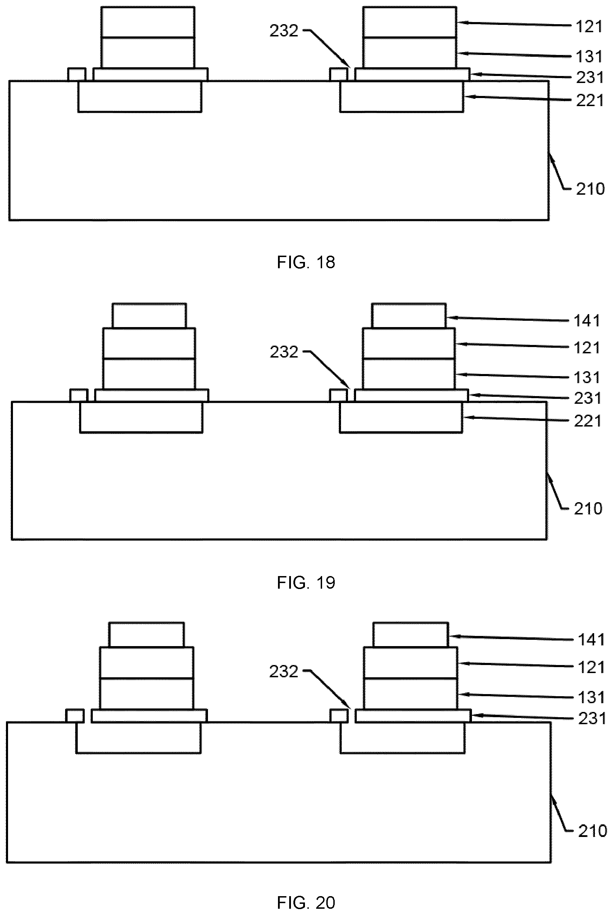

An epitaxial substrate 110 is removed to obtain a structure as shown in FIG. 18.

A patterned top electrode unit 141 is deposited on an exposed piezoelectric film element 121 according to a designed layout, as shown in FIG. 19.

The sacrificial unit 221 is removed through the release hole 232 so that a resonant cavity is formed below the bonding unit 231 to obtain the target device. A BAW filter structure described in the present disclosure is also prepared by using the preparation method of this example, as shown in FIG. 20.

The target device in this example is also an FBAR device, but it has the advantages of higher mechanical strength and better robustness compared with Example 1.

### Example 3

Compared with Example 1, a transfer structure 100 is prepared through a sample process in this example. A major difference from Example 1 is that the preparation process of a bonding structure 200 is different, resulting in a different structure of a target device.

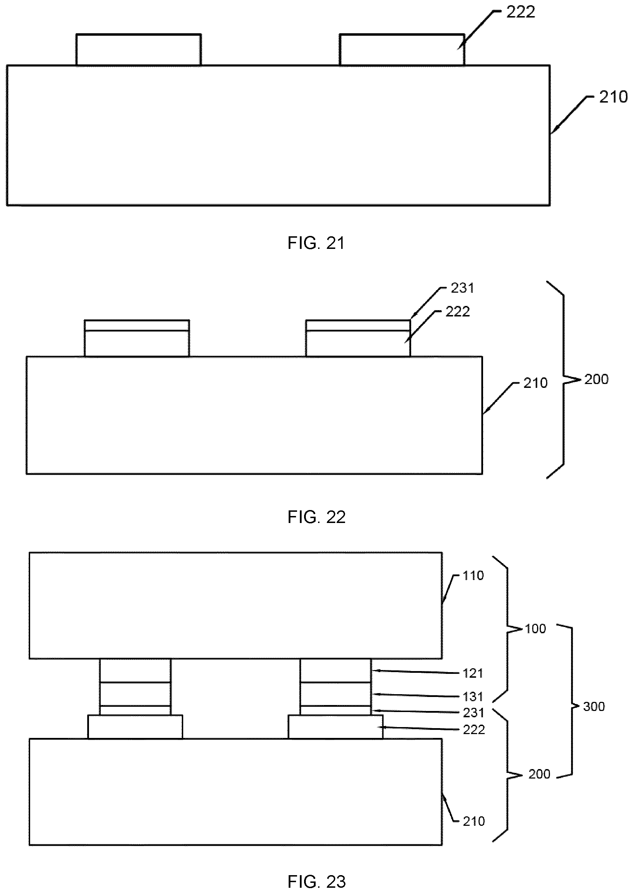

When the bonding structure 200 is prepared, a Bragg reflection unit 222 is prepared on a supporting substrate 210. The Bragg reflection unit 222 is located within a resonant region of a designed layout, as shown in FIG. 21.

The Bragg reflection unit 222 is flatly covered with a bonding unit 231 to obtain the bonding structure 200 as shown in FIG. 22.

The transfer structure 100 is reversed and bonded to the bonding structure 200 to obtain a BAW structure 300 as shown in FIG. 23.

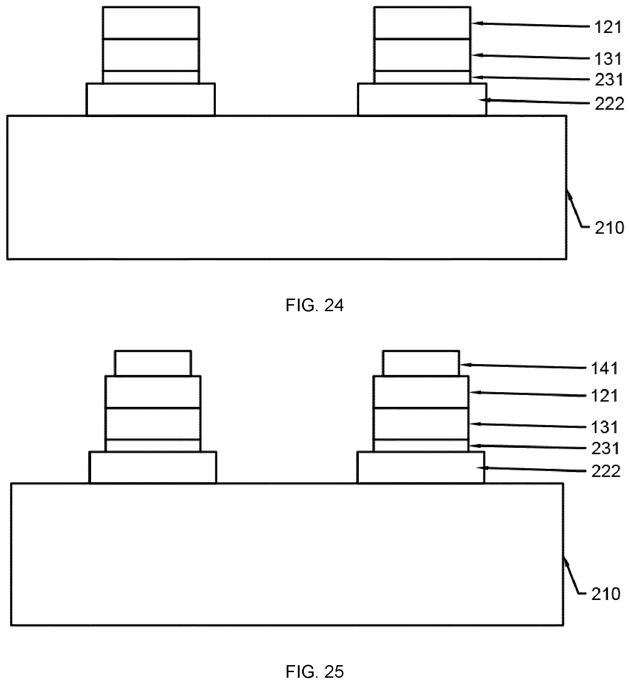

An epitaxial substrate 110 is removed, as shown in FIG. 24.

A patterned top electrode unit 141 is deposited on an exposed piezoelectric film element 121 according to a designed layout to obtain a target device. A BAW filter structure described in the present disclosure is also prepared by using the preparation method of this example, as shown in FIG. 25.

A target device in this example is an SMR device.

Corresponding changes and variations may be made by those skilled in the art according to the technical solutions and concepts described above, and all these changes and variations should fall within the protection scope of the claims of the present disclosure.

## Claims

1. A preparation method of a bulk acoustic wave (BAW) filter structure, comprising:
a step of fabricating a transfer structure (100): forming two or more piezoelectric film elements (121) independent of each other on a surface of an epitaxial substrate (110) and forming bottom electrode units (131) on the piezoelectric film elements (121) correspondingly one to one to obtain the transfer structure (100);
a step of fabricating a bonding structure (200): defining two or more resonant regions independent of each other on a supporting substrate (210), covering the resonant regions with bonding units (231), respectively, and electrically interconnecting the bonding units (231) as needed according to a patterning design to obtain the bonding structure (200), wherein a position of each resonant region is axisymmetric to a position of each piezoelectric film element (121); and
a step of transfer bonding: reversing upper and lower surfaces of the transfer structure (100) and bonding the bottom electrode units (131) to the resonant regions correspondingly one to one to obtain a BAW structure (300); and removing the epitaxial substrate (110), and forming top electrode units (141) on surfaces of the piezoelectric film elements (121) that are in contact with the epitaxial substrate (110) previously.

2. The preparation method of a BAW filter structure according to claim 1, wherein if the resonant region contains a sacrificial material, the sacrificial material is removed after the removal of the epitaxial substrate (110).

3. The preparation method of a BAW filter structure according to claim 1, wherein the bonding unit (231) is made of a metal or an alloy material.

4. The preparation method of a BAW filter structure according to claim 1, wherein after the bonding units (231) are electrically interconnected, an independently resonant one-stage or multi-stage topology is formed for a BAW filter.

5. The preparation method of a BAW filter structure according to claim 1, wherein the resonant region is provided with a sacrificial unit (221) between the bonding unit (231) and the supporting substrate (210), and the bonding unit (231) is provided with a release hole (232) for exposing the sacrificial unit (221).

6. The preparation method of a BAW filter structure according to claim 5, wherein the sacrificial unit (221) is laid on an upper surface of the supporting substrate (210).

7. The preparation method of a BAW filter structure according to claim 5, wherein a cavity for accommodating the sacrificial unit (221) is formed in the upper surface of the supporting substrate (210), and the bonding unit (231) flatly covers an upper surface of the sacrificial unit (221).

8. The preparation method of a BAW filter structure according to claim 1, wherein the resonant region is provided with a Bragg reflection unit (222) between the bonding unit (231) and the supporting substrate (210).

9. The preparation method of a BAW filter structure according to claim 1, wherein the piezoelectric film element (121) is made of a monocrystalline material or a polycrystalline material.

10. A BAW filter structure, obtained by using the preparation method according to any one of claims 1-9.
